# NEUE EUROPÄISCHE PATENTSCHRIFT

(11) **EP 3 048 721 B2**
(45) Veröffentlichungstag und Bekanntmachung des Hinweises auf die Entscheidung über den Einspruch: **04.06.2025**
(45) Hinweis auf die Patenterteilung: 30.06.2021
(21) Anmeldenummer: 15192929.6
(22) Anmeldetag: 04.11.2015
(51) Int. Cl.: H02P 29/02

(54) **VORRICHTUNG UND EIN VERFAHREN ZUR SICHEREN ANSTEUERUNG EINES HALBLEITERSCHALTERS EINES WECHSELRICHTERS**
DEVICE AND METHOD FOR SECURE ACTIVATION OF A SEMICONDUCTOR SWITCH OF AN INVERTER
DISPOSITIF ET PROCEDE DE COMMANDE FIABLE D'UN CIRCUIT SEMI-CONDUCTEUR D'UN ONDULEUR

(30) Priorität: 21.11.2014 AT 508462014
(43) Veröffentlichungstag der Anmeldung: 27.07.2016
(73) Patentinhaber: B&R Industrial Automation GmbH, 5142 Eggelsberg (AT)
(72) Erfinder: Faschang, Leopold, 5142 Eggelsberg (AT)
(74) Vertreter: Patentanwälte Pinter & Weiss OG

(56) Entgegenhaltungen:
- EP-A1- 3 065 290
- EP-A2- 1 542 330
- EP-A2- 2 495 869
- WO-A1-2014/181450
- DE-A1- 10 317 374
- DE-A1- 102008 027 113
- DE-T2- 69 310 679
- DE-T5- 112013 006 912
- JP-A- 2010 104 187
- US-A1- 2008 174 184

## Beschreibung

Die vorliegende Erfindung betrifft eine Vorrichtung und ein Verfahren zur sicheren Ansteuerung zumindest eines Treiberbausteins zum Ansteuern eines Halbleiterschalters eines Wechselrichters, wobei der Treiberbaustein den Halbleiterschalter in Abhängigkeit eines Impulssignals ansteuert, wobei eine mit dem Treiberbaustein verbundene Schaltanordnung vorgesehen ist.

Im Zusammenhang mit elektrischen Antrieben finden die unterschiedlichsten Sicherheitsfunktionen Anwendung, deren Aufgabe darin besteht, die Risiken sowohl für Mensch als auch für die Maschinen selbst, zu reduzieren.

Zu einer der gängigsten und grundlegendsten Sicherheitsfunktionen im Zusammenhang mit elektrischen Antrieben gehört die sichere Impulssperre. Im Allgemeinen wird die sichere Impulssperre als "Safe Torque Off Funktion" bzw. "STO-Funktion" bezeichnet, weshalb in diesem Zusammenhang in weiterer Folge nur noch die Bezeichnung STO-Funktion genutzt wird.

Aufgabe einer STO-Funktion ist es, dass der elektrische Antrieb drehmomentfrei geschaltet wird. Ziel ist es, dass der elektrische Antrieb keinen Strom mehr erhält, der zu einer Drehbewegung führen kann. Die STO-Funktion sorgt somit dafür, dass an einem elektrischen Antrieb kein drehmomentbildender Strom mehr wirken kann und eine fortlaufende Drehbewegung oder auch ein ungewollter Anlauf verhindert wird. Selbstverständlich gilt dies auch in analoger Weise für den Antrieb mit Linearmotoren und deren Linearbewegung.

In diesem Zusammenhang findet die STO-Funktion breite Anwendung beispielsweise in der Produktions- und Fördertechnik.

Da eine Überwachung der Stillstandsposition durch die übliche STO-Funktion selbst nicht erfolgt, wird die STO-Funktion üblicherweise dort eingesetzt, wo der Antrieb durch das Lastmoment oder durch Reibung in ausreichend kurzer Zeit selbst zum Stillstand kommt oder das Ausdrehen des Antriebs keine sicherheitstechnische Relevanz hat. Sind andernfalls zur Risikominderung keine entsprechenden Bremssysteme vorgesehen, läuft der elektrische Antrieb nach Aktivierung der STO-Funktion ungebremst aus.

Beispielsweise zeigt die EP 2 495 869 A2 ein Steuergerät mit STO-Funktion für einen elektrischen Antrieb. Eine Erzeugungseinheit erzeugt betriebszustandsabhängig eine Versorgungsspannung für die Treiber der Leistungsschalter. Diesen Treibern werden zur Ansteuerung pulsbreitenmodulierte (PWM) Impulssignale zugeführt. Wird die STO-Funktion aktiviert, beispielsweise aufgrund eines unterbrochenen Sicherheitsschalters, wird die Spannungsversorgung der Treiber unterbrochen bzw. nicht mehr zur Verfügung gestellt. Dadurch wird ein Safe-Torque-Off Zustand bewirkt, da vom Treiber keine Steuersignale mehr ausgegeben bzw. weitergegeben werden. Auch die WO 2014/181450 A1 und US 2008/174184 A1 offenbaren eine derartige Unterbrechung der Spannungsversorgung der Treiber. Die DE 693 10 679 T2 zeigt eine Überstromschutzschaltung für einen Leistungstransistor, die DE 103 17 374 A1 eine Steuerschaltung einer Dreiphasen-Inverterschaltung.

Die WO2014181450A1 offenbart eine Vorrichtung mit den jeweiligen Merkmalen der Oberbegriffe der unabhängigen Ansprüche.

Nachteilig ist dabei zu sehen, dass der Treiber einen hohen und stark schwankenden Stromverbrauch aufweist und daher zur Überbrückung von Testlücken mit großen Energiespeichern in Form von Kondensatoren gestützt werden muss. Diese beeinflussen die Reaktionszeit im negativen Sinn und führen so zu einem verzögerten Sperren des Wechselrichters, der von den Treibern angesteuert wird. Aufgrund dieser Verzögerung kommt es zu einem verspäteten Wirken der STO-Funktion und somit zu einer Reduzierung der Sicherheit, da der elektrische Antrieb verzögert drehmomentfrei geschaltet wird. Ähnliche Probleme können nicht nur bei elektrischen Antrieben auftreten, sondern grundsätzlich überall dort, wo ein Wechselrichter von Treibern angesteuert wird.

Die Aufgabe der vorliegenden Erfindung besteht darin, in Bezug auf den derzeitigen Stand der Technik, die Reaktionszeit zu verkürzen und damit die Sicherheit zu erhöhen.

Diese Aufgabe wird durch die vorliegende Erfindung dadurch gelöst, dass eine Schaltanordnung zum Anlegen eines Sperrsignals einen Schaltanschluss und zum Anlegen des Impulssignals einen ersten Anschluss aufweist, um in Abhängigkeit des Sperrsignals das am ersten Anschluss anliegende Impulssignal zum Treiberbaustein durchzuschalten oder zu sperren. Auf diese Weise wird nicht die Energieversorgung eines Treibers für die Übertragung des Impulssignals unterbrochen, sondern es wird das Impulssignal selbst gesperrt. Notwendige Energiespeicher bzw. Kondensatoren können kleiner dimensioniert werden als bei der Unterbrechung der Treiberversorgung, da nur sehr wenig Energie für die Übertragung des Impulssignals benötigt wird und somit der zu speichernde Energieanteil geringer ist. Durch die Unterbrechung des Impulssignals kommt es somit zu geringeren zeitlichen Verzögerungen und zu einem wesentlich schnelleren Auslösen der Sicherheitsfunktion als bei Schaltungen nach dem Stand der Technik.

Erfindungsgemäß ist vorgesehen, dass die Schaltanordnung durch eine Serienschaltung eines Schaltelements mit dem Schaltanschluss, eines vorgeschalteten hochohmigen Vorwiderstands mit dem ersten Anschluss und eines nachgeschalteten niederohmigen Arbeitswiderstands ausgebildet ist, ein zweiter Anschluss des hochohmigen Vorwiderstands mit einem Eingangsanschluss des Schaltelements verbunden ist und ein Ausgangsanschluss des Schaltelements mit dem niederohmigen Arbeitswiderstand verbunden ist. Eine weitere vorteilhafte Ausgestaltung sieht vor, dass das Schaltelement durch einen Transistor in Kollektorschaltung ausgeführt ist und der Eingangsanschluss durch dessen Basis, der Schaltanschluss durch dessen Kollektor und der Ausgangsanschluss durch dessen Emitter gebildet ist. In bekannter Weise stellt ein Transistor einen kontaktlosen Schalter dar. Transistoren haben geringe Schaltzeiten, sind wartungsfrei, platzsparend und besitzen eine hohe Lebensdauer.

Eine weitere erfindungsgemäße Ausgestaltung sieht vor, dass dem Schaltelement ein Vorschaltkreis, welcher einen Speicherkondensator mit einer Ladeeinrichtung und einer Entladevorrichtung beinhaltet, voran geschalten ist. Die Ladeeinrichtung ist mit dem Speicherkondensator verbunden und der Speicherkondensator mit der Entladevorrichtung und dem Schaltanschluss der Schaltanordnung verbunden. Der Speicherkondensator erlaubt es, Testlücken im Impulssperrsignal, welche beim Selbsttest vorgelagerter/verbundener Schaltungen entstehen, zu überbrücken und ein Aktivieren der STO-Funktion und somit das Einleiten der Impulssperre zu vermeiden.

Weiters ist vorteilhaft vorgesehen, dass die Ladeeinrichtung aus zumindest einem Übertragungskondensator besteht. Dieser stellt sicher, dass lediglich Wechselspannung die Ladeeinrichtung passieren kann.

Vorteilhaft ist vorgesehen, dass der Vorschaltkreis eine dynamisierte optischen Kopplung zur Umwandlung des Sperrsignals in eine Wechselspannung beinhaltet, welche zur Übertragung der Wechselspannung mit der Ladeeinrichtung verbunden ist. Dadurch ist sichergestellt, dass einem Fehler in der Galvanischen Trennung/ optischen Kopplung das Sperrsignal von der nachfolgenden Ladeeinrichtung nicht übertragen werden kann.

Eine weitere vorteilhafte Ausgestaltung sieht vor, dass die optische Kopplung eine Rückkoppelschleife beinhaltet, welche zumindest aus einem Hysteresekomparator und einem zweiten Optokoppler gebildet ist. Dadurch kann die optische Kopplung in einfacher Weise dynamisiert werden.

Vorteilhaft ist vorgesehen, dass die Entladevorrichtung mit dem Schaltelement zur Stromversorgung des Schaltelements verbunden ist. Im Falle des Auslösens der Sicherheitsfunktion wird der Speicherkondensator nicht nur durch die Stromabgabe an das Schaltelement, sondern auch über die Entladevorrichtung entladen. Dadurch, dass das Schaltelement von der Entladeeinheit mit Strom versorgt wird, wird eine zeitliche Verzögerung minimiert und ein wesentlich schnelleres Auslösen der Sicherheitsfunktion ermöglicht

In vorteilhafter Weise ist vorgesehen, dass der hochohmige Vorwiderstand durch die Serienschaltung von zwei hochohmigen Vorwiderständen gebildet ist. Sollte somit einer der beiden Widerstände einen Defekt aufweisen und es zu einem Kurzschluss kommen, ist der sich ergebende Summenwiderstand noch immer ausreichend hoch, um eine erfindungsgemäße Funktion zu gewährleisten.

In weiterer vorteilhafter Weise ist vorgesehen, dass der niederohmige Arbeitswiderstand durch eine Parallelschaltung von zwei niederohmigen Arbeitswiderständen gebildet ist. Auch in diesem Fall ist bei Ausfall eines der beiden Widerstände die erfindungsgemäße Funktion weiterhin gewährleistet.

Weiters ist ein entsprechendes Verfahren vorgesehen, gemäß dem unabhängigen Anspruch 8.

In vorteilhafter Weise findet die Vorrichtung zur sicheren Impulssperre einer elektrischen Last, die von einem Wechselrichter angesteuert wird, Verwendung.

In weiterer vorteilhafter Weise wird die elektrische Last durch einen Wechselstromantrieb gebildet.

Die gegenständliche Erfindung wird nachfolgend unter Bezugnahme auf die Figuren 1 bis 6 näher erläutert, die beispielhaft, schematisch und nicht einschränkend vorteilhafte Ausgestaltungen der Erfindung zeigen. Dabei zeigt
Fig.1 eine sichere Ansteuerung einer elektrischen Last in Form einer Safe Torque Off Schaltung nach Stand der Technik,
Fig.2 ein Blockschaltbild einer Safe Torque Off Schaltung nach Stand der Technik,
Fig.3 ein vereinfachtes Blockschaltbild einer Vorrichtung zur sicheren Ansteuerung eines Halbleiterschalters eines Wechselrichters,
Fig.4 das Blockschaltbild einer Ausgestaltung der erfindungsgemäßen Vorrichtung,
Fig.5 eine vorteilhafte Ausgestaltung der erfindungsgemäßen Vorrichtung,
Fig.6 einen Schaltplan der erfindungsgemäßen Vorrichtung in einer besonders vorteilhaften Ausgestaltung.

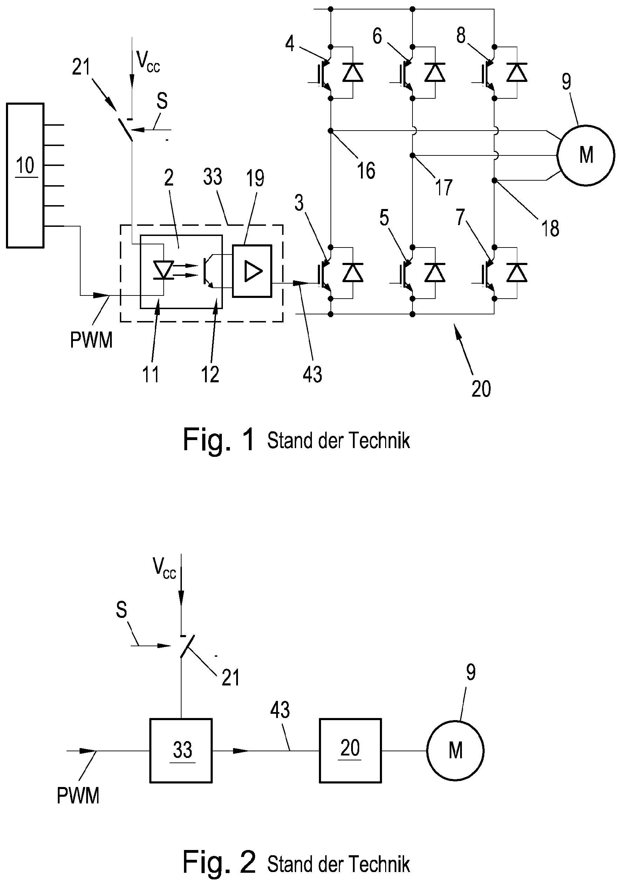

Figur 1 zeigt eine sichere Ansteuerung einer elektrischen Last 9, in diesem Fall einen Drehstrommotor, in Form einer üblichen Safe Torque Off Schaltung 1 nach Stand der Technik. Eine derartige Safe Torque Off Schaltung, kurz STO-Schaltung, wird als Sicherheitsfunktion beispielsweise vom Institut für Arbeitsschutz vorgegeben.

Wie in Figur 1 erkennbar ist, wird ein Optokoppler 2 dazu genutzt, ein Steuersignal 43 an eine elektrische Last 9 bzw. die zur Ansteuerung genutzten Halbleiterschalter 3 bis 8 zu übertragen. Dieser Optokoppler 2 ist üblicherweise in einem Treiberbaustein 33, üblicherweise als Gatetreiber bezeichnet, angeordnet. Als Gatetreiber werden in bekannter Weise diskrete oder integrierte Schaltungen zur Ansteuerung eines Halbleiterschalters 3 bis 8 bezeichnet. Der Optokoppler stellt dabei eine galvanische Trennung zwischen einem Regler 10 und den Halbleiterschaltern 3 bis 8 dar. Die galvanische Trennung muss nicht zwangsläufig durch Optokoppler 2 erfolgen, auch induktive, kapazitive und andere Trennungen sind möglich. In Fällen, in denen eine galvanische Trennung nicht erforderlich ist, kann auf diese auch gänzlich verzichtet werden.

Grundsätzlich wird für jeden Halbleiterschalter 3 bis 8 ein eigener Treiberbaustein 33 genutzt. Die Figur 1 stellt jedoch, rein schematisch, lediglich einen dieser Treiberbausteine 33 dar.

Die STO-Funktion nach Stand der Technik basiert darauf, dass ein von einem Regler 10 ausgegebenes Impulssignal PWM zwar an einen Treiberbaustein 33 weitergegeben wird, jedoch der Treiberbaustein 33 nicht mit Energie versorgt wird, wenn die STO-Funktion, beispielsweise durch eine nicht weiter dargestellte, übergeordnete Regeleinheit, aktiviert ist. Als Impulssignal PWM können unterschiedlichste Signalmodulationen zur Anwendung kommen. Nur Beispielhaft und nicht weiter einschränkend seien die Pulsweiten-/ Pulsbreitenmodulation, Pulsdauermodulation und die Pulsfrequenzmodulation genannt.

Im Falle der in Figur 1 dargestellten Anordnung nach Stand der Technik wird die Versorgungsspannung Vcc des Treiberbausteins 33 durch einen ersten Schalter 21 unterbrochen. Der erste Schalter 21 wird dabei durch ein Impulssperrsignal S unterbrochen, wenn die STO-Funktion, beispielsweise durch eine nicht weiter dargestellte, übergeordnete Regeleinheit aktiviert ist. Dabei ist zu bemerken, dass beispielsweise eine aktive STO-Funktion bzw. Impulssperre bedeutet, dass das Impulssperrsignal STO nicht zur Verfügung gestellt wird. Da die Sekundärseite 12 des Optokopplers 2 des Treiberbausteins 33 mit einem der Halbleiterelemente 3 bis 8 verbunden ist, werden die Steuersignale 43 auf der Sekundärseite 12, aufgrund der fehlenden Versorgungsspannung Vcc auf der Primärseite 11 des Optokopplers 2, nicht generiert.

Da die Treiberbausteine 33 alle mit derselben Versorgungsspannung Vcc versorgt werden, könnten mit einem Impulssperrsignal S und einem Schalter 21 alle Treiberbausteine 33 unterbrochen werden.

Wie weiters in Figur 1 erkennbar ist, werden zur Ansteuerung der elektrischen Last 9 in bekannter Weise ein Wechselrichter 20 mit einer Halbbrücke je Phase, hier beispielsweise eine erste Halbbrücke 13, eine zweiten Halbbrücke 14 und eine dritten Halbbrücke 15 für eine beispielhafte, dreiphasige elektrische Last 19 genutzt. In jeder der Halbbrücken 13, 14 und 15 sind zwei Halbleiterelemente 3 bis 8 angeordnet, wobei der elektrische Antrieb 9, entsprechend der drei Phasen, mit einem ersten Knotenpunkt 16, einem zweiten Kontenpunkt 17 und einem dritten Knotenpunkt 18 verbunden ist. Die drei Knotenpunkte 16, 17 und 18 sind dabei so angeordnet, dass der erste Knotenpunkt 16 zwischen den zwei Halbleiterelementen 3 und 4 liegt, der zweite Knotenpunkt 17 zwischen den beiden Halbleiterelementen 5 und 6 liegt und der dritte Knotenpunkt 18 zwischen den beiden Halbleiterelementen 7 und 8 liegt. Jedes Halbleiterelement 3 bis 8 wird dabei, wie oben beschrieben, von einem eigenen Treiberbaustein 33 angesteuert. Diese grundlegende Schaltung eines Wechselrichters ist hinlänglich bekannt, weshalb hier nicht näher darauf eingegangen wird. Nur beispielhaft ist in Figur 1 im Treiberbaustein 33 ein üblicherweise vorgesehener Impulsverstärker 19 zur Signalverstärkung angedeutet. Selbstverständlich können die elektrische Last 9 und der Wechselrichter 20 auch mit jeder anderen Phasenanzahl realisiert sein.

Figur 2 zeigt ein vereinfachtes Blockschaltbild einer Safe-Torque-Off Schaltung 1 nach Stand der Technik. Dieses Blockschaltbild fasst das eben für Figur 1 beschriebene, nochmals in Form einer vereinfachten Darstellung zusammen.

Ein Treiberbaustein 33 zur Ansteuerung der Leistungsschalter bzw. Halbleiterelemente 3 bis 8 eines Wechselrichters 20 für eine elektrische Last 9 wird bei nicht aktiviertem STO mit Energie in Form der Versorgungsspannung Vcc, versorgt. Weiters wird dem Treiberbaustein 33, in bekannter Weise, das Impulssignal PWM zugeführt. Nach Stand der Technik wird im Zuge einer sicheren Impulssperre bzw. einer aktivierten STO-Funktion die Energieversorgung des Treibers unterbrochen.

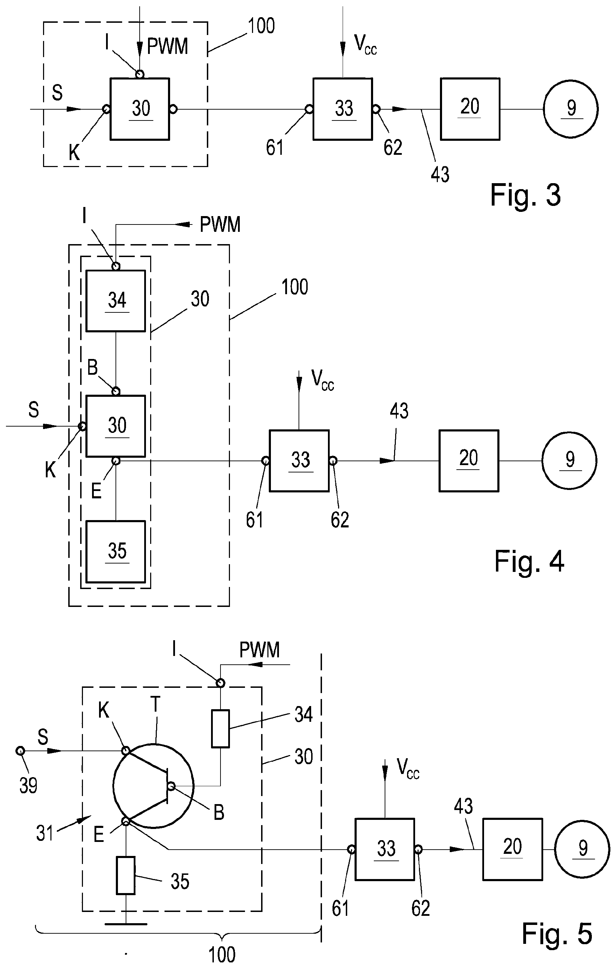

Figur 3 zeigt im Gegensatz dazu ein vereinfachtes Blockschaltbild der erfindungsgemäßen Vorrichtung 100. Wie schematisch erkennbar ist, ist ein Wechselrichter 20, der eine elektrische Last 9 mit einer Wechselspannung versorgt, vorgesehen. Dabei wird ein Treiberbaustein 33 genutzt, der einen Halbleiterschalter des Wechselrichters 20 in Abhängigkeit von einem Impulssignal PWM ansteuert. Weiters ist eine mit dem Treiberbaustein 33 verbundene Schaltanordnung 30 vorgesehen, welche zum Anlegen eines Sperrsignals S einen Schaltanschluss K und zum Anlegen des Impulssignals PWM einen ersten Anschluss I aufweist, um in Abhängigkeit des Sperrsignals S das am ersten Anschluss I anliegende Impulssignal PWM zum Treiberbaustein 33 auf den Ausgangsanschluss E durchzuschalten oder zu sperren. Wie erkennbar ist, ist im Gegensatz zum Stand der Technik eine Unterbrechung der Energie- bzw. Versorgungsspannung Vcc des Treiberbausteins 33 nicht vorgesehen.

Unter "Sperren" wird in diesem Zusammenhang das Unterbrechen eines Signalpfades zum Treiberbaustein 33 verstanden. Ist dieser Signalpfad nicht gesperrt bzw. nicht unterbrochen, wird das Impulssignal PWM zum Treiberbaustein 33 durchgeschalten bzw. zu diesem weitergeleitet und der Treiberbaustein 33 kann ein Steuersignal 43 an den Wechselrichter 20 ausgeben. Nur dann kann eine elektrische Last 9 mit einer Wechselspannung versorgt werden. Erfindungsgemäß wird also eine Schaltanordnung 30 genutzt, um direkt den Signalpfad des Impulssignals PWM zum Treiberbaustein 33 zu unterbrechen. Auf diese Weise wird eine bereits erwähnte Sicherheitsfunktion realisiert.

Die Schaltanordnung 30 wird, je nach Bedarf, über das Sperrsignal S geschaltet, welches beispielsweise von einer nicht weiter dargestellten übergeordneten Regeleinrichtung zur Verfügung gestellt wird.

Figur 4 zeigt das Blockschaltbild einer vorteilhaften Ausgestaltung der erfindungsgemäßen Vorrichtung 100.

Dabei ist die Schaltanordnung 30 durch eine Serienschaltung eines Schaltelements 31, eines vorgeschalteten hochohmigen Vorwiderstands 34 und eines nachgeschalteten niederohmigen Arbeitswiderstands 35 ausgebildet. Das Schaltelement 31 weist den Schaltanschluss K, den Ausgangsanschluss E der Schaltanordnung 30 und den Eingangsanschluss B auf. Der hochohmigen Vorwiderstand 34 weist den ersten Anschluss I auf. Ein zweiter Anschluss des hochohmigen Vorwiderstands 34 ist mit einem Eingangsanschluss B des Schaltelements 31 verbunden. Der Ausgangsanschluss E des Schaltelements 31ist mit dem niederohmigen Arbeitswiderstand 35 verbunden. Der Treiberbaustein 33 besitzt einen Treibereingang 61, welcher mit dem Ausgangsanschluss E des Schaltelements 31 verbunden ist. Zur Ausgabe eines Steuersignals 43, weist der Treiberbaustein 33 weiters einen Steuerausgang 62, welcher mit einem Halbleiterschalter des Wechselrichters 20 verbunden ist, auf. Figur 5 zeigt dazu eine weitere vorteilhafte Ausgestaltung, bei welcher das Schaltelement 31 durch einen Transistor T in Kollektorschaltung ausgeführt ist und der Eingangsanschluss B durch dessen Basis, der Schaltanschluss K durch dessen Kollektor und der Ausgangsanschluss E durch dessen Emitter gebildet ist. Transistoren stellen kostengünstige Bauteile dar, haben geringe Schaltzeiten, sind wartungsfrei, platzsparend und besitzen eine hohe Lebensdauer. Dennoch wäre anstelle des Transistors T als Schaltelement 31 auch die Verwendung eines entsprechenden Logikgatters denkbar. Auch andere Transistorschaltungen sind gegebenenfalls einsetzbar. Im Weiteren wird jedoch auf die besonders vorteilhafte Ausführungsvariante unter Nutzung eines Transistors T in Kollektorschaltung (auch als Emitterfolger bezeichnet) Bezug genommen.

Bei der Kollektorschaltung eines Transistors T fließt am Eingangsanschluss B (hier die Basis des Transistors T) bekanntermaßen ein um die Stromverstärkung geringerer Strom als im Ausgangsanschluss E (hier der Emitter des Transistors T). Dadurch verursacht der mit dem Eingangsanschluss B verbundene hochohmige Vorwiderstand 34 einen unerheblichen Spannungsabfall und es ergibt sich eine Spannungsverstärkung von annähernd eins. Zur Stromverstärkung kommt es allerdings nur dann, wenn zwischen dem Schaltanschluss K (hier der Kollektor des Transistors T) und dem Ausgangsanschluss E Spannung anliegt.

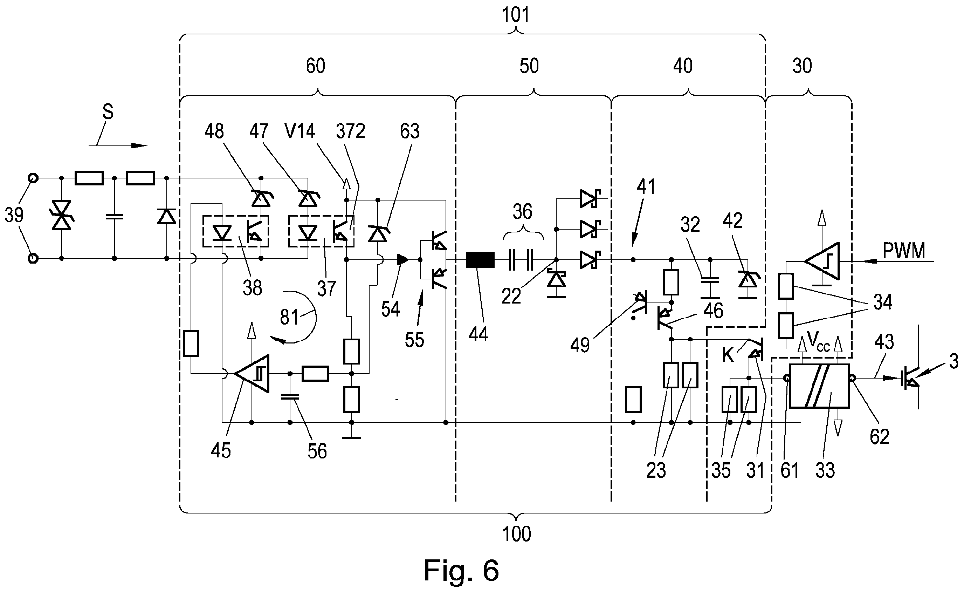

Wird also der Schaltanschluss K aufgrund des an einer Eingangsklemme 39 anliegenden Sperrsignals S mit Spannung versorgt, kommt es zur Stromverstärkung und das Impulssignal PWM, welches am Eingangsanschluss B bzw. der Basis des Transistors T anliegt, wird nahezu unverändert auf den Ausgangsanschluss E durchgeschaltet. Anders, wenn der Schaltanschluss K nicht versorgt ist, wenn also an der Eingangsklemme 39 keine Spannung anliegt. Der Transistor T wirkt dann nicht verstärkend. Das Impulssignal PWM wird in diesem Fall entsprechend der Spannungsteilerregel erheblich abgeschwächt, wobei der Spannungsteiler aus dem hochohmigen Vorwiderstand 34 und dem niederohmigen Arbeitswiderstand 35 gebildet wird. Die am niederohmigen Arbeitswiderstand 35 abfallende Spannung ist dabei zu gering, um den Treiberbaustein 33 anzusteuern. Zwischen dem Ausgangsanschluss E und dem Treiberbaustein 33 können, entgegen der Figur 5 und der nachfolgend beschriebenen Figur 6, weitere Schaltungen oder Bauteile, wie beispielsweise MOSFET Transistoren eingefügt sein, ohne den erfindungsgemäßen Gedanken zu verändern.

Für die hochohmigen Vor- und /oder niederohmigen Arbeitswiderstände 34, 35 werden ausfallsichere Widerstände (auch als betriebsbewährt bezeichnet) verwendet. Weiters wird der hochohmige Vorwiderstand 34 durch eine Serienschaltung von zwei hochohmigen Vorwiderständen 34 gebildet. Analog dazu wird der niederohmige Arbeitswiderstand 35 durch eine Parallelschaltung von zwei niederohmigen Arbeitswiderständen 35 gebildet. Das Widerstandsverhältnis wird so gewählt, dass auch bei Totalausfall eines hochohmigen Vor- und/oder niederohmigen Arbeitswiderstands 34, 35 die erforderliche Spannungsabschwächung gewährleistet ist. Andernfalls, könnte auch ohne Stromverstärkung durch den Transistor T ein so großer Spannungsabfall auftreten, dass der Treiberbaustein 33 aktiviert werden könnte. Um zu gewährleisten, dass der Treiberbaustein 33 sicher nicht angesteuert werden kann, wenn die STO Funktion aktiviert ist, darf der hochohmige Vorwiderstand 34 nie niederohmig und der Arbeitswiderstandwiderstand 35 nie hochohmig werden. Als hoch- bzw. niederohmig ist zu verstehen, dass der niederohmige Arbeitswiederstand 35 einen geringeren elektrischen Wiederstand aufweist als der hochohmige Vorwiederstand 34.

Es ist daher augenscheinlich, dass das notwendige Steuersignal 43 zum Ansteuern eines Halbleiterschalters 3 nur dann vom Treiberbaustein 33 zur Verfügung gestellt werden kann, wenn am Schaltanschluss K des Transistors T ein Sperrsignal S, insbesondere in Form einer elektrischen Spannung, anliegt. Wird also das Sperrsignal S nicht zur Verfügung gestellt bzw. unterbrochen, wird auf diese Weise die elektrische Last 9 nicht angesteuert, da das Impulssignal PWM nicht durchgeschaltet wird.

Dadurch ist eine Maßnahme getroffen, durch welche, im Zusammenhang mit Sicherheitsklassifikationen in der Automatisierungstechnik, die Vorrichtung 100 als "sicher" bezeichnet werden kann. Dies bedeutet, dass mit entsprechender Wahrscheinlichkeit ein Ansteuern des Treiberbausteins 33 unterbunden wird, wenn die STO Funktion aktiviert ist.

Um die Sicherheit der bereits beschriebenen Vorrichtung 100 noch weiter zu erhöhen, kann vorgesehen sein, dass das Sperrsignal S nicht direkt an den Schaltanschluss K des Schaltelements 31 bzw. an den Kollektor des Transistors T angelegt wird. Wie in Figur 6 schematisch dargestellt ist, kann das Sperrsignal S vor dem Schaltelement 31 noch durch einen Vorschaltkreis 101 geführt werden.

Die Vorrichtung 100, wie sie in Figur 6 dargestellt ist, gliedert sich in vier Funktionseinheiten:
30) Schaltanordnung,
40) Speicherkondensator und Stromquelle als Teil des Vorschaltkreises 101,
50) Ladeeinrichtung auch als Teil des Vorschaltkreises 101,
60) optische Kopplung ebenfalls als Teil des Vorschaltkreises 101.

Der Vorschaltkreis 101, bzw. dessen drei zugehörigen Funktionseinheiten Stromquelle 40, Ladeeinrichtung 50 und optische Kopplung 60, werden mit Bezugnahme auf Figur 6, welche einen Schaltplan der erfindungsgemäßen Vorrichtung 100 in einer besonders vorteilhaften Ausgestaltung zeigt, beschrieben.

Dazu ist anzumerken, dass eine Variante des Vorschaltkreises 101 denkbar ist, welche lediglich die Stromquelle 40 beinhaltet.

Findet die Vorrichtung 100 für ein Dreiphasendrehstromnetz Anwendung, kann beispielsweise am Knotenpunkt 22 die Schaltung in mehrere gleiche Teile, beispielsweise in drei für die drei Phasen des Drehstromnetzes, aufgeteilt werden. Auch eine Aufteilung in sechs gleiche Teile, unter Berücksichtigung von High-Side und Low-Side-Halbleiterschalter, ist denkbar. Mit Bezugnahme auf den in Figur 1 dargestellten Wechselrichter sei erwähnt, dass die Halbleiterbauelemente 4, 6 und 8 oberhalb der Knotenpunkte 16, 17 und 18 aufgrund ihrer Lage im Schaltkreis bekannter Weise als High Side Halbleiterbauelemente und die Halbleiterbauelemente 3, 5 und 7 als Low Side Halbleiterbauelemente bezeichnet werden. Die Vorrichtung 100 kann selbstverständlich auch im Zusammenhang mit Wechselrichtern genutzt werden, welche einen anderen Aufbau, als den eben erwähnten, aufweisen.

Die in Figur 6 rechts vom Knotenpunkt 22 dargestellten Funktionseinheiten Speicherkondensator und Stromquelle 40 und auch die Schaltanordnung 30, können in diesem Fall für jede der drei Phasen bzw. für jedes Schaltelement 31 separat und in gleicher Weise ausgeführt sein, wie auch in Figur 6 angedeutet.

Wird das Sperrsignal S von einer nicht weiter dargestellten, übergeordneten Regeleinrichtung zur Verfügung gestellt, können im Sperrsignal S periodisch kurzzeitige Spannungseinbrüche, als Testlücken bezeichnet, mit einer Dauer von beispielsweise 60 - 400µs auftreten. Diese rühren von einem üblichen Selbsttest bei sicherheitsrelevanten Regeleinrichtungen her. Mithilfe dieser Testlücken prüft die nicht weiter dargestellte, übergeordnete Regeleinrichtung ihre eigene Funktionstüchtigkeit. Da jedoch die Unterbrechung des Sperrsignals S lediglich Testzwecken dient, und nicht der Aktivierung der Sicherheitsfunktion entspricht, muss die Vorrichtung 100 während der Testlücke den Halbleiterschalter 3 weiter ansteuern bzw. die elektrische Last 9 weiter mit Wechselspannung versorgt werden.

Für diesen Fall kann vorgesehen sein, dass der Schaltanordnung 30 ein Vorschaltkreis 101 voran geschalten ist. Der Vorschaltkreis 101 beinhaltet einen Speicherkondensator 32 mit einer Ladeeinrichtung 50 und einer Entladevorrichtung 41 beinhaltet. Die Ladeeinrichtung 50 ist mit dem Speicherkondensator 32 verbunden. Weiters ist der Speicherkondensator 32 mit der Entladevorrichtung 41 und dem Schaltanschluss K der Schaltanordnung 30 verbunden.

Der Speicherkondensator 32 wird durch die Ladeeinrichtung 50, bestehend aus zumindest einem Übertragungskondensator 36, kontinuierlich geladen. Dies stellt einen gewissen Ladezustand des Speicherkondensators 32 sicher, so dass bereits erwähnte Testlücken überbrückt werden können. Grundsätzlich versorgt der Speicherkondensator 32 die Schaltanordnung 30 über den Schaltanschluss K während der Testlücken weiterhin mit Energie. Der Speicherkondensator 32 ist in seiner Dimensionierung vorzugsweise so ausgelegt, dass gerade ermöglicht wird, eine Testlücke genannter zeitlicher Länge zu überbrücken und das Schaltelement 31 während der Testlücke mit Strom zu versorgen.

Die Entladevorrichtung 41 sorgt dafür, dass der Speicherkondensator 32 über zumindest einen Grundlastwiderstand 23 kontinuierlich bzw. in vorhersehbarer Zeit entladen wird. Die Entladevorrichtung 41 ist mit dem Schaltelement 31 verbunden und stellt in Kombination mit dem Speicherkondensator 32 gleichzeitig jene Stromquelle dar, über welche das Schaltelement 31 bzw. der Transistor T mit Strom versorgt wird. Bei der Entladevorrichtung 41 handelt es sich vorteilhafterweise um eine Konstantstromquelle, welche in bekannter Weise, wie in Figur 6 erkennbar ist, aus einem ersten Regeltransistor 46 und einem damit verschalteten zweiten Regeltransistor 49 aufgebaut sein kann.

Durch die kontinuierliche Entladung des Speicherkondensators 32 kann dieser, im Falle eines Auslösens der Sicherheitsfunktion nur noch so lange das Schaltelement 31 bzw. den Transistor T versorgen, wie es zur Überbrückung von Testlücken notwendig ist.

Im Falle des Auslösens der Sicherheitsfunktion wird der Speicherkondensator 32 nicht nur durch die Stromabgabe an das Schaltelement 31, sondern auch über die Entladevorrichtung 41 in vorhersehbarer Zeit entladen. Dem Schaltelement wird dabei nur noch während dieser vorhersehbaren Zeit Strom zur Verfügung gestellt. Dadurch wird eine zeitliche Verzögerung minimiert und ein wesentlich schnelleres Auslösen der Sicherheitsfunktion ermöglicht als ohne kontinuierliche Entladung des Speicherkondensators 32 durch eine Entladevorrichtung 41.

Wie Figur 6 zeigt, ist parallel zum Speicherkondensator 32 eine Zenerdiode 42 angeordnet. Diese sorgt lediglich dafür, dass bei einem möglicherweise zu hohen Spannungsniveau der Speicherkondensator 32 nicht höher geladen wird, als es die Durchbruchspannung der Zenerdiode 42 erlaubt. Damit kann der Speicherkondensator 32 auf einer definierten Spannung gehalten werden.

Gleichzeitig wird der Speicherkondensator 32 durch die vorangeschaltete Ladeeinrichtung 50 laufend geladen, wenn ein Sperrsignal S zur Verfügung gestellt wird, was zusammen mit dem Funktionsblock der optischen Kopplung 60 beschrieben wird.

Um die Sicherheit zu erhöhen, wird der Speicherkondensator 32 ohne galvanische Verbindung, zur Eingangsklemme 39, an welchen das Sperrsignal S anliegt, versorgt. Am Eingang der Vorrichtung 100 kann ein üblicher Eingangsschutz vorgesehen sein. Dieser schützt die nachfolgenden Bauteile in bekannter Weise vor Überspannungen, Verpolung, usw. Eine derartige Einrichtung ist in der Regelungstechnik durchaus bekannt, weshalb auf diesen Schaltungsteil nicht näher eingegangen wird.

Die galvanische Trennung erfolgt innerhalb der optischen Kopplung 60 durch einen ersten Optokoppler 37. Um im Falle eines Optokopplerdefekts sicherzustellen, dass keine Energie zum Speicherkondensator 32 übertragen wird, erfolgt die Energieübertragung kapazitiv über die Ladeeinrichtung 50. Dabei ist zu berücksichtigen, dass im Fall eines Defekts die Möglichkeit bestünde, dass der erste Optokoppler 37 eine kontinuierliche Kopplung herstellt. Dabei würde ein gleichbleibendes Spannungsniveau am Ausgang 372 des Optokopplers 37 anliegen. Da jedoch die anschließende Ladeeinrichtung 50 aus zumindest einem Übertragungskondensator 36 besteht und dieser bekanntlich nur Wechselspannung übertragen kann, würde der Speicherkondensator 32 nicht geladen werden.

Das Sperrsignal S wird jedoch durch eine Gleichspannungsgröße gebildet. Um es so aufzubereiten, dass es über die Ladeeinrichtung 50 übertragen werden kann, ist vorgesehen, dass im Vorschaltkreis 101 die optischen Kopplung 60 zur Umwandlung des Sperrsignals S in eine Wechselspannung dynamisiert ist. Die Wechselspannung wird dann an die Ladeeinrichtung 50 übertragen, welche mit der optischen Kopplung 60 verbunden ist. Um die, für die Energieübertragung in der Ladeeinrichtung 50, bereits zuvor erwähnte notwendige Wechselspannung zu generieren, wird die Vorrichtung 100 innerhalb ihres Vorschaltkreises 101 bzw. der optischen Kopplung 60 dynamisiert. Dies erfolgt durch eine in der optischen Kopplung 60 integrierte Rückkoppelschleife 81, bestehend aus zumindest einem Hysteresekomparator 45, einem Verzögerungsglied 56 und einem zweiten Optokoppler 38.

Ausgangspunkt für die Dynamisierung ist, dass das Sperrsignal S in Form einer Gleichspannung am ersten Optokoppler 37 anliegt und diesen aktiviert. Wie aus Figur 6 ersichtlich ist, ist die Sekundärseite 372 des ersten Optokopplers 37 mit dem Hysteresekomparator 45 über ein Verzögerungsglied 56 verbunden. Das Verzögerungsglied 56 enthält einen Kondensator, im Weiteren als Dynamisierkondensator bezeichnet. Bei Aktivierung des ersten Optokopplers 37 wird der Dynamisierkondensator geladen, in der Folge gibt der Hysteresekomparator 45 bei Erreichen seiner oberen Schaltschwelle ein High-Signal an den zweiten Optokoppler 38 weiter. Dadurch wird der zweite Optokoppler 38 aktiviert und das Sperrsignal S wird kurzgeschlossen. Infolge dessen wird der erste Optokoppler 37 deaktiviert. Nun wird der Dynamisierkondensator so lange entladen, bis der Hysteresekomparator 45 seine untere Schaltschwelle erreicht, wodurch an den zweiten Optokoppler 38 kein High-Signal mehr weitergeleitet wird. Dieser ist daher wiederum deaktiviert, das Sperrsignal S liegt wieder am ersten Optokoppler 37 an und versorgt diesen erneut.

Aufgrund dieses dynamisch wechselnden Vorgangs, wird am Ausgang 372 des Optokopplers 37 eine Wechselspannung generiert.

Bei einem Bauteildefekt innerhalb der Rückkoppelschleife 81 steht ungünstigstenfalls eine konstante Spannung am Übertragungskondensator 36 der Ladeeinrichtung 50 an. Wie bereits ausgeführt, kommt es in diesem Fall zwangsläufig zu keiner Energieübertragung über den Übertragungskondensator 36.

Wie in Figur 6 erkennbar, ist zwischen optischen Koppler 60 und Ladeeinrichtung 50 eine Treiberstufe 55 vorgesehen, die in bekannter Weise das Ausgangssignal 54 des optischen Kopplers 60 entsprechend verstärkt, so dass der Ladeeinrichtung 50 ausreichend viel Energie zur weiteren Übertragung zur Verfügung steht.

In der anschließenden Ladeeinrichtung 50 kann zur Erhöhung der Sicherheit natürlich auch vorgesehen werden, dass der bereits erwähnte Übertragungskondensator 36 durch eine Serienschaltung mehrerer Übertragungskondensatoren 36 gebildet wird. Sollte einer der Übertragungskondensatoren 36 defekt sein und einen Kurzschluss verursachen, kommt es, im Falle eines dauernd leitenden Optokopplers, aufgrund eines weiteren Übertragungskondensators 36 dennoch zu keiner Energieübertragung. In Figur 6 sind beispielhaft zwei Übertragungskondensatoren 36 in Serie geschalten. Die weiters in Serie zum Übertragungskondensator 36 geschaltene Induktivität 44 der Ladeeinrichtung 50 ist vorteilhaft, ist jedoch nicht zwingend notwendig. Sie dient vorrangig der Spannungserhöhung und der Vermeidung von Ladestromspitzen. Vorteilhaft ist auch das Bandpassverhalten, also das Sperren von Frequenzen außerhalb eines erwünschten Durchlassbereiches, durch die Kombination aus Induktivität und Übertragungskondensator.

Die in der optischen Kopplung 60 im Bereich des ersten Optokopplers 37 vorgesehene erste Zenerdiode 47 sorgt dafür, dass die Einschaltschwelle mindestens so hoch ist, wie es für Steuereingänge in einschlägigen Normen vorgeschrieben wird. Erst wenn die Durchbruchspannung, üblicherweise im Bereich von fünf Volt, der ersten Zenerdiode 47 erreicht wird, kann der erste Optokoppler 37 aktiviert werden. Die weitere, geeignet bemessene zweite Zenerdiode 48 im Bereich des zweiten Optokopplers 38 stellt sicher, dass bei einem Ausfall bzw. Kurzschluss der ersten Zenerdiode 47 die bereits beschriebene Dynamisierung nicht möglich wird. Bei Kurzschluss oder einer zu geringen Durchbruchspannung der ersten Zenerdiode 47 ließe sich der erste Optokoppler 37 nicht durch den zweiten Optokoppler 38 sperren. Der erste Optokoppler 37 wäre in diesem Fall während eines an Klemme 39 anstehenden Sperrssignals S ständig aktiv, was einem Gleichspannungssignal entspräche. Dies wäre zwar kein "gefährlicher" Zustand da bei anliegendem Sperrsignal S der Treiberbaustein 33 ohnehin angesteuert werden soll, es fehlt jedoch an der oben erwähnten Dynamisierung. Dadurch kann es über die nachfolgende Ladeeinrichtung 50 zu keiner Energieübertragung kommen. Ein derartiger Fehler in der optischen Kopplung 60 wird somit umgehend erkennbar, da der Treiberbaustein 33 nicht weiter angesteuert wird, obwohl das Sperrsignal S nicht unterbrochen ist.

Die in Figur 6 im Bereich der optischen Kopplung 60 dargestellte dritte Zenerdiode 63 dient der Sicherheit in Bezug auf eine Überspannung der elektrischen Versorgungsspannung V14. Im Falle einer Überspannung wird die Zenerdiode 63 leitend und als Folge gibt der zuvor erwähnte Hysteresekomparator 45 anhaltend ein Highsignal aus. Dadurch wird von der optischen Kopplung 60 keine Wechselspannung erzeugt, welche über die Ladeeinrichtung 50 übertragen werden könnte.

Alternativ zur erwähnten dargestellten galvanischen Trennung in der optischen Kopplung 60 mittels Optokoppler 37 und 38 wäre auch eine induktive Form der Energieübertragung mittels Transformator und vorgeschaltetem Zerhacker möglich.

Wird die Sicherheitsfunktion, beispielsweise von der übergeordneten, nicht weiter dargestellten Regeleinheit angefordert, liegt an der Eingangsklemme 39 keine Spannung an. In weiterer Folge wird der Speicherkondensator 32 nicht mehr geladen, da die optischen Kopplung 60 keine Wechselspannung generiert und über die Ladeeinrichtung 50 keine Energie transportiert wird. Falls in dieser Zeit gerade keine Steuersignale 43 ausgegeben werden und daher die Schaltanordnung 30 keinen Strom aufnimmt, muss die Entladeeinrichtung 40 die im Speicherkondensator 32 gespeicherte elektrische Energie auf einem anderen Weg abführen. Dies kann beispielsweise über eine parallel zur Schaltanordnung 30 liegende Zenerdiode oder, wie in Fig. 6 dargestellt, durch einen Grundlastwiderstand 23 erfolgen. Dadurch, dass der Speicherkondensator 32, wie zuvor beschrieben, kontinuierlich und in jedem Fall entladen wird, ist sichergestellt, dass die Entladung in einer vorhersehbaren Zeit erfolgt.

In vorteilhafter Weise findet die Vorrichtung 100 zur sicheren Impulssperre einer elektrischen Last, die von einem Wechselrichter 20 angesteuert wird, Verwendung. Dabei wird die elektrische Last 9 vorteilhaft durch einen Wechselstromantrieb gebildet.

Unter Wechselstromantrieb sind dabei übliche Elektroantriebe wie Wechselstrommotoren, Drehstrommotoren und dergleichen zu verstehen. Dabei wird der Wechselstromantrieb, aufgrund der oben beschriebenen Vorgänge, nicht weiter mit Wechselspannung versorgt, wenn das Sperrsignal S nicht an der Eingangsklemme 39 angelegt wird. Auf diese Weise kommt es zu einer Impulssperre und der Wechselstromantrieb wird drehmomentfrei geschaltet. In dieser Weise wird durch die Vorrichtung 100 für einen Wechselstromantrieb eine bereits eingangs erwähnte Safe Torque Off Funktion realisiert.

Dies gilt in völlig analoger Weise, wenn die elektrische Last 9 durch einen Linearmotor gebildet wird, wobei infolge der Impulssperre keine Kraft mehr vom Linearmotor ausgeübt werden kann.

Durch die oben beschriebene und in den Figuren 3 bis 6 dargestellte Vorrichtung 100 für eine elektrische Last 9, bzw. einen elektrischen Antrieb, ist daher, in Bezug auf den derzeitigen Stand der Technik, aufgrund einer wesentlich verringerten Reaktionszeit der Schaltung, die Sicherheit entsprechend erhöht.

## Patentansprüche

1. Vorrichtung (100) zur sicheren Ansteuerung zumindest eines Treiberbausteins (33) zum Ansteuern eines Halbleiterschalters (3) eines Wechselrichters (20), wobei der Treiberbaustein (33) den Halbleiterschalter in Abhängigkeit eines Impulssignals (PWM) ansteuert, wobei eine mit dem Treiberbaustein (33) verbundene Schaltanordnung (30) vorgesehen ist, **dadurch gekennzeichnet, dass die** Schaltanordnung (30) zum Anlegen eines Sperrsignals (S) einen Schaltanschluss (K) und zum Anlegen des Impulssignals (PWM) einen ersten Anschluss (I) aufweist, um in Abhängigkeit des Sperrsignals (S) das am ersten Anschluss (I) anliegende Impulssignal (PWM) zum Treiberbaustein (33) durchzuschalten oder zu sperren **und dass** der Schaltanordnung (30) ein Vorschaltkreis (101) voran geschalten ist, der Vorschaltkreis (101) einen Speicherkondensator (32) mit einer Ladeeinrichtung (50) und eine Entladevorrichtung (41) beinhaltet, die Ladeeinrichtung (50) mit dem Speicherkondensator (32) verbunden ist und der Speicherkondensator (32) mit der Entladevorrichtung (41) und dem Schaltanschluss (K) der Schaltanordnung (30) verbunden ist.

2. Vorrichtung (100) nach Anspruch 1, **dadurch gekennzeichnet, dass** die Schaltanordnung (30) durch eine Serienschaltung eines Schaltelements (31) mit dem Schaltanschluss (K), eines vorgeschalteten hochohmigen Vorwiderstands (34), vorzugsweise durch die Serienschaltung von zwei hochohmigen Vorwiderständen gebildet, mit dem ersten Anschluss (I) und eines nachgeschalteten niederohmigen Arbeitswiderstands (35), vorzugsweise durch eine Parallelschaltung von zwei niederohmigen Arbeitswiderständen gebildet, ausgebildet ist, ein zweiter Anschluss des hochohmigen Vorwiderstands (34) mit einem Eingangsanschluss (B) des Schaltelements (31) verbunden ist und ein Ausgangsanschluss (E) des Schaltelements (31) mit dem niederohmigen Arbeitswiderstand (35) verbunden ist.

3. Vorrichtung (100) nach Anspruch 2, **dadurch gekennzeichnet, dass** das Schaltelement (31) durch einen Transistor (T) in Kollektorschaltung ausgeführt ist und der Eingangsanschluss (B) durch dessen Basis, der Schaltanschluss (K) durch dessen Kollektor und der Ausgangsanschluss (E) durch dessen Emitter gebildet ist

4. Vorrichtung (100) nach Anspruch 1, **dadurch gekennzeichnet, dass** die Ladeeinrichtung (50) zumindest einen Übertragungskondensator (36) umfasst.

5. Vorrichtung (100) nach einem der Ansprüche 1 oder 4, **dadurch gekennzeichnet, dass** der Vorschaltkreis (101) eine dynamisierte optischen Kopplung (60) zur Umwandlung des Sperrsignals (S) in eine Wechselspannung beinhaltet, welche zur Übertragung der Wechselspannung mit der Ladeeinrichtung (50) verbunden ist.

6. Vorrichtung (100) nach Anspruch 5, **dadurch gekennzeichnet, dass** die optische-Kopplung (60) eine Rückkoppelschleife (81) beinhaltet, welche zumindest aus einem Hysteresekomparator (45), einem Verzögerungsglied (56) und einem Optokoppler (38) gebildet ist.

7. Vorrichtung (100) nach einem der Ansprüche 1 bis 6, **dadurch gekennzeichnet, dass** die Entladevorrichtung (41) mit dem Schaltelement (31) zur Stromversorgung des Schaltelements (31) verbunden ist.

8. Verfahren zur sicheren Ansteuerung eines Halbleiterschalters (30) eines Wechselrichters (20), der eine elektrische Last (9) mit einer Wechselspannung versorgt, wobei über einen Treiberbaustein (33) der Halbleiterschalter (30) in Abhängigkeit von einem Impulssignal (PWM) angesteuert wird, **dadurch gekennzeichnet, dass** das am Treiberbaustein (33) anliegende Impulssignal (PWM) mittels eines Schaltelements (31) in Abhängigkeit von einem Sperrsignal (S) durchgeschaltet oder gesperrt wird **und dass** der Schaltanordnung (30) ein Vorschaltkreis (101) voran geschalten wird, wobei der Vorschaltkreis (101) einen Speicherkondensator (32) mit einer Ladeeinrichtung (50) und eine Entladevorrichtung (41) beinhaltet, die Ladeeinrichtung (50) mit dem Speicherkondensator (32) verbunden ist und der Speicherkondensator (32) mit der Entladevorrichtung (41) und dem Schaltanschluss (K) der Schaltanordnung (30) verbunden ist.

9. Verfahren nach Anspruch 8, **dadurch gekennzeichnet, dass** das Schaltelement (31) von einer Entladevorrichtung (41) mit Strom versorgt wird, in dem ein Speicherkondensator (32) durch die Entladevorrichtung (41) über zumindest einen Grundlastwiderstand (23) kontinuierlich entladen wird.

10. Verfahren nach Anspruch 9, **dadurch gekennzeichnet, dass** der Speicherkondensator (32) durch eine Ladeeinrichtung (50), umfassend zumindest einen Übertragungskondensator (36), kontinuierlich geladen wird.

11. Verfahren nach Anspruch 10, **dadurch gekennzeichnet, dass** die Ladeeinrichtung (50) durch eine dynamisierte optische Kopplung (60) mit Wechselspannung versorgt wird.

12. Verfahren nach Anspruch 11, **dadurch gekennzeichnet, dass** das an der optischen Kopplung (60) anliegende Sperrsignal (S) unter Verwendung eines ersten Optokopplers (37) und einer Rückkoppelschleife (81) aus zumindest einem Hysteresekomparator (45), einem Verzögerungsglied (56) und einem zweiten Optokoppler (38) in der optischen Kopplung (60) dynamisiert wird.

13. Verwendung der Vorrichtung (100) nach den Ansprüchen 1 bis 7 zur sicheren Impulssperre einer elektrischen Last (9), die von einem Wechselrichter (20) angesteuert wird.

14. Verwendung der Vorrichtung (100) nach Anspruch 13, **dadurch gekennzeichnet, dass** die elektrische Last (9) durch einen Wechselstromantrieb gebildet ist.

15. Vorrichtung (100) zur sicheren Ansteuerung zumindest eines Treiberbausteins (33) zum Ansteuern eines Halbleiterschalters (3) eines Wechselrichters (20), wobei der Treiberbaustein (33) den Halbleiterschalter in Abhängigkeit eines Impulssignals (PWM) ansteuert, wobei eine mit dem Treiberbaustein (33) verbundene Schaltanordnung (30) vorgesehen ist, **dadurch gekennzeichnet, dass die** Schaltanordnung (30) zum Anlegen eines Sperrsignals (S) einen Schaltanschluss (K) und zum Anlegen des Impulssignals (PWM) einen ersten Anschluss (I) aufweist, um in Abhängigkeit des Sperrsignals (S) das am ersten Anschluss (I) anliegende Impulssignal (PWM) zum Treiberbaustein (33) durchzuschalten oder zu sperren, **und dass** die Schaltanordnung (30) durch eine Serienschaltung eines Schaltelements (31) mit dem Schaltanschluss (K), eines vorgeschalteten hochohmigen Vorwiderstands (34) mit dem ersten Anschluss (I) und eines nachgeschalteten niederohmigen Arbeitswiderstands (35) ausgebildet ist, ein zweiter Anschluss des hochohmigen Vorwiderstands (34) mit einem Eingangsanschluss (B) des Schaltelements (31) verbunden ist und ein Ausgangsanschluss (E) des Schaltelements (31) mit dem niederohmigen Arbeitswiderstand (35) verbunden ist.

## Claims

1. A device (100) for safe control of at least one driver module (33) for controlling a semiconductor switch (3) of an inverter (20), wherein the driver module (33) controls the semiconductor switch in dependence on a pulse signal (PWM), wherein a switching arrangement (30) which is connected with the driver module (33) is provided, **characterized in that** the switching arrangement (30) has a switching connection (K) for applying an inhibition signal (S) and a first connection (I) for applying the pulse signal (PWM), in order to either inhibit or switch through the pulse signal (PWM) applied to the first connection (I) to the driver module (33), depending on the inhibition signal (S) and **in that** a ballast circuit (101) is switched ahead of the switching arrangement (30), the ballast circuit (101) includes a storage capacitor (32) with a charging apparatus (50) and a discharging device (41), the charging apparatus (50) is connected with the storage capacitor (32) and the storage capacitor (32) is connected with the discharging device (41) and the switching connection (K) of the switching arrangement (30).

2. The device (100) according to claim 1, **characterized in that** the switching arrangement (30) is formed by a series connection of a switching element (31) with the switching connection (K), an upstream high-impedance series resistor (34), preferably formed by the series connection of two high-impedance series resistors, with the first connection (I) and a downstream low-impedance load resistor (35), preferably formed by a parallel connection of two low-impedance load resistors, a second connection of the high-impedance series resistor (34) is connected with an input connection (B) of the switching element (31) and an output connection (E) of the switching element (31) is connected with the low-impedance load resistor (35).

3. The device (100) according to claim 2, **characterized in that** the switching element (31) is designed as a transistor (T) in a common collector and that the input connection (B) is formed as the base thereof, the switching connection (K) is formed as the collector thereof and the output connection (E) is formed as the emitter thereof.

4. The device (100) according to claim 1, **characterized in that** the charging apparatus (50) comprises at least one transfer capacitor (36).

5. The device (100) according to one of claims 1 or 4, **characterized in that** the ballast circuit (101) includes a dynamized optical coupling (60) for converting the inhibition signal (S) to an AC voltage, which is connected to the charging apparatus (50) for transmitting the AC voltage.

6. The device (100) according to claim 5, **characterized in that** the optical coupling (60) includes a feedback loop (81) which is formed at least from a hysteresis comparator (45), a delay element (56) and a optocoupler (38).

7. The apparatus (100) according to any one of claims 1 to 6, **characterized in that** the discharging device (41) is connected with the switching element (31) for supplying the switching element (31) with current.

8. A method for safe control of a semiconductor switch (30) of an inverter (20), which supplies an electrical load (9) with AC voltage, wherein a driver module (33) controls the semiconductor switch in dependence on a pulse signal (PWM), **characterized in that** the pulse signal (PWM) applied to the driver module (33) is switched through or inhibited depending on an inhibition signal (S) by means of a switching element (31) and **in that** a ballast circuit (101) is switched ahead of the switching arrangement (30), the ballast circuit (101) including a storage capacitor (32) with a charging apparatus (50) and a discharging device (41), the charging apparatus (50) being connected with the storage capacitor (32) and the storage capacitor (32) being connected with the discharging device (41) and the switching connection (K) of the switching arrangement (30).

9. The method according to claim 8, **characterized in that** the switching element (31) is supplied with current by a discharging device (41), **in that** a storage capacitor (32) is continuously discharged by the discharging device (41) via at least one base load resistor (23).

10. The method according to claim 9, **characterized in that** the storage capacitor (32) is continuously charged by the charging apparatus (50), comprising at least one transfer capacitor (36).

11. The method according to claim 10, **characterized in that** the charging apparatus (50) is supplied with AC voltage by means of a dynamized optical coupling (60).

12. The method according to claim 11, **characterized in that** the inhibition signal (S) applied to the optical coupling (60) is made dynamic in the optical coupling (60) by means of a first optocoupler (37) and a feedback loop (81) of at least one hysteresis comparator (45), a delay element (56) and a second optocoupler (38).

13. The use of the device (100) according to claims 1 to 7 for safe pulse inhibition of an electrical load (9), which is controlled by an inverter (20).

14. The use of the device (100) according to claim 13, **characterized in that** the electrical load (9) is formed as an AC drive.

15. A device (100) for safe control of at least one driver module (33) for controlling a semiconductor switch (3) of an inverter (20), wherein the driver module (33) controls the semiconductor switch in dependence on a pulse signal (PWM), wherein a switching arrangement (30) which is connected with the driver module (33) is provided, **characterized in that** the switching arrangement (30) has a switching connection (K) for applying an inhibition signal (S) and a first connection (I) for applying the pulse signal (PWM), in order to either inhibit or switch through the pulse signal (PWM) applied to the first connection (I) to the driver module (33), depending on the inhibition signal (S), and **in that** the switching arrangement (30) is formed by a series connection of a switching element (31) with the switching connection (K), an upstream high-impedance series resistor (34), with the first connection (I) and a downstream low-impedance load resistor (35), a second connection of the high-impedance series resistor (34) is connected with an input connection (B) of the switching element (31) and an output connection (E) of the switching element (31) is connected with the low-impedance load resistor (35).

## Revendications

1. Dispositif (100) permettant la commande sécurisée d'au moins un module de pilote (33) pour commander un commutateur à semi-conducteur (3) d'un onduleur (20), le module de pilote (33) commandant le commutateur à semi-conducteur en fonction d'un signal d'impulsion (PWM), un agencement de commutation (30) relié au module de pilote (33) étant prévu, **caractérisé en ce que** l'agencement de commutation (30) présente une borne de commutation (K) pour appliquer un signal de blocage (S) et une première borne (I) pour appliquer le signal d'impulsion (PWM), afin de commuter ou de bloquer le signal d'impulsion (PWM) appliqué à la première borne (I) vers le module de pilotage (33) en fonction du signal de blocage (S) **et en ce que** l'agencement de commutation (30) est précédé d'un circuit ballast (101), le circuit ballast (101) contient un condensateur de stockage (32) comportant un appareil de charge (50) et un dispositif de décharge (41), l'appareil de charge (50) est connecté au condensateur de stockage (32) et le condensateur de stockage (32) est connecté au dispositif de décharge (41) et à la borne de commutation (K) de l'agencement de commutation (30).

2. Dispositif (100) selon la revendication 1, **caractérisé en ce que** l'agencement de commutation (30) est formé par un circuit en série d'un élément de commutation (31) avec la borne de commutation (K), d'une résistance en série à haute impédance (34) en amont, de préférence formée par le circuit en série de deux résistances en série à haute impédance, avec la première borne (I) et d'une résistance de travail de basse impédance (35) en aval, de préférence formée par un circuit en parallèle de deux résistances de travail de basse impédance, qu'une seconde borne de la résistance en série à haute impédance (34) est connectée à une borne d'entrée (B) de l'élément de commutation (31) et qu'une borne de sortie (E) de l'élément de commutation (31) est connectée à la résistance de travail de basse impédance (35).

3. Dispositif (100) selon la revendication 2, **caractérisé en ce que** l'élément de commutation (31) est réalisé par un transistor (T) dans un circuit à collecteur et que la borne d'entrée (B) est formée sur la base de celui-ci, que la borne de commutation (K) est formée par le collecteur du transistor et que la borne de sortie (E) est formée par l'émetteur du transistor.

4. Dispositif (100) selon la revendication 1, **caractérisé en ce que** l'appareil de charge (50) comprend au moins un condensateur de transmission (36).

5. Dispositif (100) selon l'une des revendications 1 ou 4, **caractérisé en ce que** le circuit ballast (101) contient un couplage optique (60) dynamisé permettant de convertir le signal de blocage (S) en une tension alternative, ledit couplage optique dynamisé étant connecté à l'appareil de charge (50) pour transmettre la tension alternative.

6. Dispositif (100) selon la revendication 5, **caractérisé en ce que** le couplage optique (60) contient une boucle de rétroaction (81) qui est formée au moins par un comparateur d'hystérésis (45), un élément retardateur (56) et un optocoupleur (38).

7. Dispositif (100) selon l'une des revendications 1 à 6, **caractérisé en ce que** le dispositif de décharge (41) est connecté à l'élément de commutation (31) pour alimenter en courant électrique l'élément de commutation (31).

8. Procédé permettant la commande sécurisée d'un commutateur à semi-conducteur (30) d'un onduleur (20) qui alimente une charge électrique (9) comportant une tension alternative, le commutateur à semi-conducteur (30) étant commandé par l'intermédiaire d'un module de commande (33) en fonction d'un signal d'impulsion (PWM), **caractérisé en ce que** le signal d'impulsion (PWM) appliqué au module de commande (33) est commuté ou bloqué au moyen d'un élément de commutation (31) en fonction d'un signal de blocage (S) **en ce que** l'agencement de commutation (30) est précédé d'un circuit ballast (101), le circuit ballast (101) contient un condensateur de stockage (32) comportant un appareil de charge (50) et un dispositif de décharge (41), l'appareil de charge (50) est connecté au condensateur de stockage (32) et le condensateur de stockage (32) est connecté au dispositif de décharge (41) et à la borne de commutation (K) de l'agencement de commutation (30).

9. Procédé selon la revendication 8, **caractérisé en ce que** l'élément de commutation (31) est alimenté en courant par un dispositif de décharge (41) dans lequel un condensateur de stockage (32) est déchargé en continu par le dispositif de décharge (41) par l'intermédiaire d'au moins une résistance de charge de base (23).

10. Procédé selon la revendication 9, **caractérisé en ce que** le condensateur de stockage (32) est chargé en continu par un appareil de charge (50) comprenant au moins un condensateur de transmission (36).

11. Procédé selon la revendication 10, **caractérisé en ce que** l'appareil de charge (50) est alimenté en tension alternative par un couplage optique (60) dynamisé.

12. Procédé selon la revendication 11, **caractérisé en ce que** le signal de blocage (S) appliqué au couplage optique (60) est dynamisé à l'aide d'un premier optocoupleur (37) et d'une boucle de rétroaction (81), constituée d'au moins un comparateur d'hystérésis (45), un élément retardateur (56) et un second optocoupleur (38) dans le couplage optique (60).

13. Utilisation du dispositif (100) selon les revendications 1 à 7 permettant le blocage sécurisé d'impulsions d'une charge électrique (9) commandée par un onduleur (20).

14. Utilisation du dispositif (100) selon la revendication 13, **caractérisée en ce que** la charge électrique (9) est formée par un entraînement à courant alternatif.

15. Dispositif (100) permettant la commande sécurisée d'au moins un module de pilote (33) pour commander un commutateur à semi-conducteur (3) d'un onduleur (20), le module de pilote (33) commandant le commutateur à semi-conducteur en fonction d'un signal d'impulsion (PWM), un agencement de commutation (30) relié au module de pilote (33) étant prévu, **caractérisé en ce que** l'agencement de commutation (30) présente une borne de commutation (K) pour appliquer un signal de blocage (S) et une première borne (I) pour appliquer le signal d'impulsion (PWM), afin de commuter ou de bloquer le signal d'impulsion (PWM) appliqué à la première borne (I) vers le module de pilotage (33) en fonction du signal de blocage (S) **et en ce que** l'agencement de commutation (30) est formé par un circuit en série d'un élément de commutation (31) avec la borne de commutation (K), d'une résistance en série à haute impédance (34) en amont, avec la première borne (I) et d'une résistance de travail de basse impédance (35) en aval, qu'une seconde borne de la résistance en série à haute impédance (34) est connectée à une borne d'entrée (B) de l'élément de commutation (31) et qu'une borne de sortie (E) de l'élément de commutation (31) est connectée à la résistance de travail de basse impédance (35).
